# EUROPEAN PATENT SPECIFICATION

(11) **EP 2 690 804 B1**
(45) Date of publication and mention of the grant of the patent: **05.02.2020**
(21) Application number: 13178210.4
(22) Date of filing: 26.07.2013
(51) Int. Cl.: H04B 11/00, H02G 1/02, B06B 3/00, G01R 15/26, H02J 50/15, B06B 1/06, H02N 2/18, H01L 27/20

(54) **High voltage interface device and method based on ultrasound**
Hochspannungsschnittstellenvorrichtung und Verfahren auf der Basis von Ultraschall
Dispositif d'interface à haute tension et procédé basé sur des ultrasons

(30) Priority: 27.07.2012 CN 201210264264
(43) Date of publication of application: 29.01.2014
(73) Proprietor: Siemens Aktiengesellschaft, 80333 München (DE)
(72) Inventor: Song, Ying Hua, 100012 Beijing (CN); Yao, Ji Long, 100102 Beijing (CN); Zhao, Yan Feng, 100012 Beijing (CN)
(74) Representative: Patentanwaltskanzlei WILHELM & BECK

(56) References cited:
- CN-A- 101 309 057
- CN-A- 101 950 660
- DENG FANG-QING ET AL: "Radiation Acoustic Field of a Linear Phased Array on a Cylindrical Surface", CHINESE PHYSICS LETTERS, INSTITUTE OF PHYSICS PUBLISHING, BRISTOL, GB, vol. 23, no. 12, 1 December 2006 (2006-12-01), pages 3297-3300, XP020097376, ISSN: 0256-307X, DOI: 10.1088/0256-307X/23/12/049

## Description

### Technical field

The present invention relates to high voltage interface technology, in particular to a high voltage interface device based on ultrasound.

### Background art

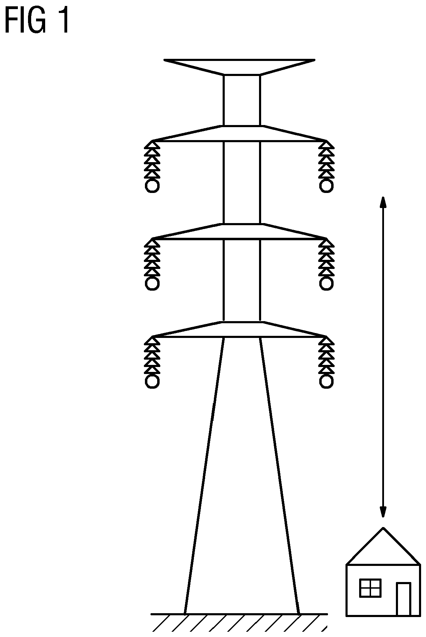

In high voltage or ultra-high voltage fields such as power delivery or power distribution, it is generally necessary to sample electrical parameters in a trunk line in real time, for the purpose of automatic control. As shown in Fig. 1, a sensor assembly is usually fitted to a trunk line attachment while a controller is installed on the ground, so that the potential difference between the sensor assembly and the controller may reach the range of thousands of volts to tens of thousands of volts. Therefore it is difficult to supply electricity from the controller to the sensor assembly and at the same time obtain sample data from the sensor assembly.

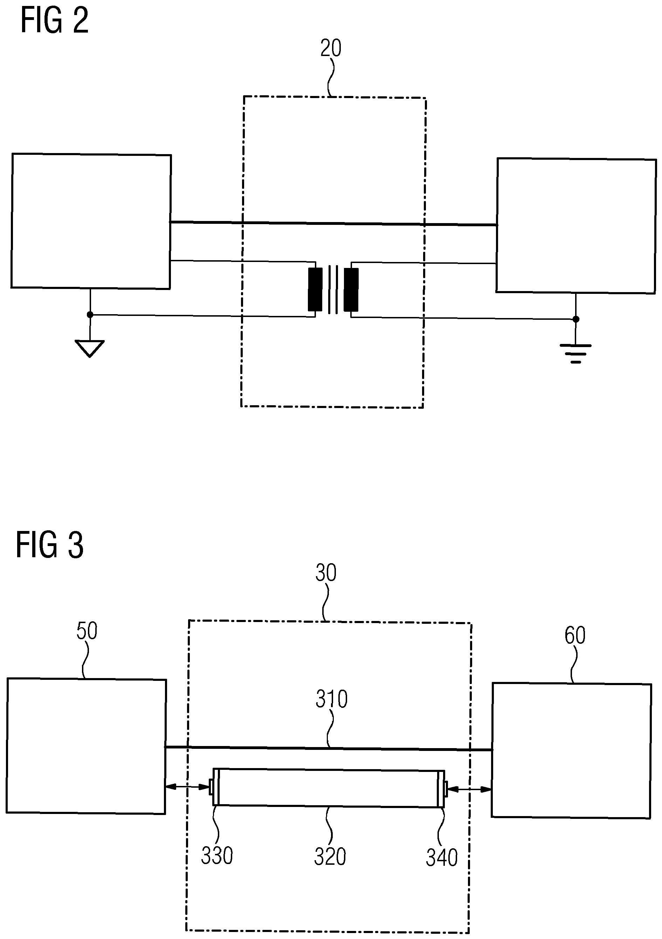

Fig. 2 shows the high voltage interface device 20 which is most commonly used at present; this consists of two parts, namely an isolating transformer and optical fiber. The isolating transformer has relatively high isolating capability and can transmit electrical power from the controller on the low voltage side to the sensor assembly on the high voltage side effectively, while the optical fiber enables reliable communication between the two.

However, since such a high voltage interface device uses an isolating transformer, the weight and volume thereof will increase steadily as the insulation level of the isolating transformer increases, as will the cost.

CN 101 309 057 A discloses the feature of the first part of claim 1. A similar device is disclosed by CN 101 950 660 A.

### Content of the invention

In view of the above problem, the present invention provides a high voltage interface device and method, which have such advantages as good high voltage isolation capability, relatively low weight and volume, and a comparatively low cost.

According to one aspect of the present invention, a high voltage interface device according to claim 1 is provided. Preferred embodiments are addressed in the dependent claims.

According to another aspect of the present disclosure, not according to the invention, a high voltage interface device is provided, comprising: an insulation device for transmitting ultrasonic waves; a first ultrasonic transducer element, one end of which is positioned at one end of the insulation device; and a second ultrasonic transducer element, one end of which is positioned at the other end of the insulation device; wherein the first ultrasonic transducer element is used for converting an inputted electrical power signal to a first ultrasonic wave and transmitting the same to the insulation device, and the second ultrasonic transducer element is used for converting the first ultrasonic wave from the insulation device to an electrical power signal to be outputted; the first ultrasonic transducer element is further used for converting an inputted electrical modulation signal to a second ultrasonic wave and transmitting the same to the insulation device, and the second ultrasonic transducer element is used for converting the second ultrasonic wave from the insulation device to an electrical modulation signal to be outputted; the second ultrasonic transducer element is further used for converting an inputted electrical modulation signal to a third ultrasonic wave and transmitting the same to the insulation device, and the first ultrasonic transducer element is used for converting the third ultrasonic wave from the insulation device to an electrical modulation signal to be outputted.

Within a first time period, a first ultrasonic transducer element array is used for converting an inputted electrical power signal to an ultrasonic wave, and a second ultrasonic transducer element array is used for receiving an ultrasonic wave from the first ultrasonic transducer element array via the insulation device and converting the same to an electrical power signal to be outputted; within a second period of time, the second ultrasonic transducer element array is used for converting an inputted electrical modulation signal to an ultrasonic wave, and the first ultrasonic transducer element array is used for receiving an ultrasonic wave from the second ultrasonic transducer element array via the insulation device and converting the same to an electrical modulation signal to be outputted.

A portion of the ultrasonic transducer elements in the first ultrasonic transducer element array is used for converting an inputted electrical power signal to an ultrasonic wave, and a portion of the ultrasonic transducer elements in the second ultrasonic transducer element array is used for receiving an ultrasonic wave from a portion of the ultrasonic transducer elements in the first ultrasonic transducer element array via the insulation device and converting the same to an electrical power signal to be outputted; the remaining portion of the ultrasonic transducer elements in the second ultrasonic transducer element array is used for converting an inputted electrical modulation signal to an ultrasonic wave, and the remaining portion of the ultrasonic transducer elements in the first ultrasonic transducer element array is used for receiving an ultrasonic wave from the remaining portion of the ultrasonic transducer elements in the second ultrasonic transducer element array via the insulation device and converting the same to an electrical modulation signal to be outputted.

The insulation device comprises a glass tube filled with distilled water.

The first and second ultrasonic transducer element arrays are piezoelectric ceramic element arrays.

The piezoelectric ceramic elements in the piezoelectric ceramic element arrays are identical, and the resonant frequency of the piezoelectric ceramic elements is equal to the frequency of the electrical power signal and electrical modulation signal.

An ultrasonic wave emitted by an ultrasonic transducer element located at one end of the insulation device can be focused on the surface of a corresponding ultrasonic transducer element located at the other end of the insulation device by phased array technology.

According to another aspect of the present disclosure, not according to the invention, a method for interacting under high voltage conditions is provided, comprising: coupling a high voltage interface device as described above between a controller on a low voltage side and a sensor assembly on a high voltage side, wherein the first ultrasonic transducer element array is coupled to the controller, and the second ultrasonic transducer element array is coupled to the sensor assembly.

**The following detailed description of the present invention with reference to the accompanying drawings will make the above and other objects, features, solutions and advantages of the present invention more obvious.**

### Description of the accompanying drawings

Preferred embodiments of the present invention will be described in detail below with reference to the accompanying drawings, to give those skilled in the art a clearer understanding of the above and other features and advantages of the present invention. In the drawings:
Fig. 1 shows a schematic diagram of the high potential difference between a sensor assembly and a controller;
Fig. 2 shows a schematic diagram of a conventional high voltage interface device;
Fig. 3 shows a schematic diagram of a high voltage interface device according to one embodiment of the present invention;
Fig. 4 shows a schematic diagram of a high voltage interface device according to an explanatory example, but not according to the present invention; and
Fig. 5 shows a schematic diagram of the microstructure of the ultrasonic transducer element array according to the present invention.

### Particular embodiments

The present invention is described in further detail below by way of embodiments, in order to clarify the object, technical solution and advantages thereof.

Fig. 3 shows a schematic diagram of a high voltage interface device according to one embodiment of the present invention.

The high voltage interface device 30 shown in Fig. 3 may comprise an optical fiber 310, an insulation device 320 suitable for transmitting ultrasonic waves, and first ultrasonic transducer elements 330 and second ultrasonic transducer elements 340 disposed at either end of the insulation device 320. The high voltage interface device 30 can serve the function of supplying electricity from a low voltage side to a high voltage side, the two sides being isolated from each other, to supply electricity to an apparatus with micro-power consumption. For instance, the high voltage interface device 30 can be coupled between a controller 50 on the low voltage side and a sensor assembly 60 on the high voltage side, transmitting electrical energy from the controller 50 into the sensor assembly 60. The optical fiber 310 may be used for communication between the two. In addition, the first ultrasonic transducer elements 330 are used for converting electrical energy inputted from the controller 50, i.e. an electrical power signal, to an ultrasonic wave; the ultrasonic wave is transmitted along the insulation device 320 to the second ultrasonic transducer elements 340, which convert the ultrasonic wave received to a corresponding electrical power signal, i.e. electrical energy, and output this signal to the sensor assembly 60. Generally known technology may be used to enable the sensor assembly 60 to convert the electrical power signal received thereby to a supply voltage capable of allowing the various components thereof to operate normally. In this embodiment, since an isolating transformer is replaced by ultrasonic transducer elements and an insulation device suitable for transmitting ultrasonic waves, **the high voltage interface device is not only capable of high voltage isolation, but is of light weight and small volume. In addition, the production cost thereof is relatively low.**

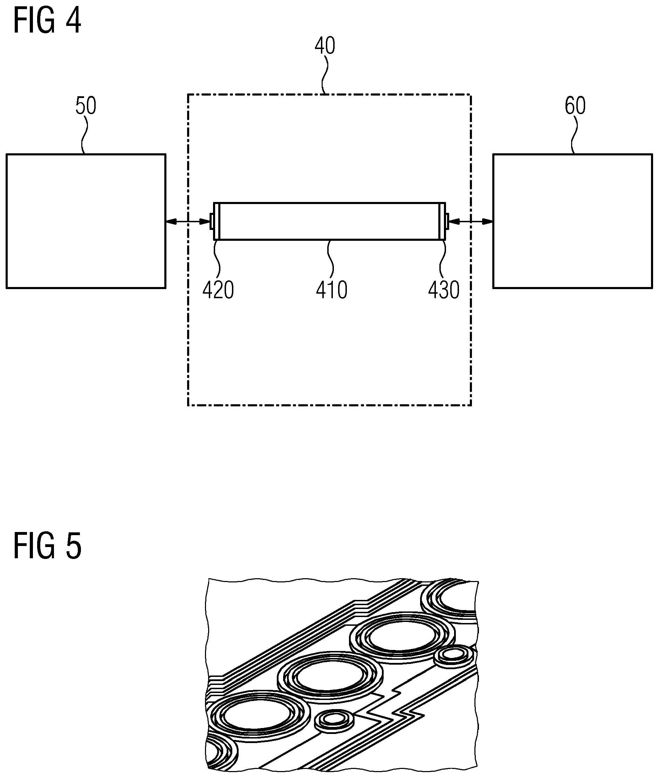

Fig. 4 shows a schematic diagram of a high voltage interface device not according to the invention. As Fig. 4 shows, a high voltage interface device 40 may comprise an insulation device 410 suitable for transmitting ultrasonic waves, and ultrasonic transducer elements 420 and 430 disposed at either end of the insulation device 410. **The high voltage interface device 40 can serve the function of supplying electricity from a low voltage side to a high voltage side, the two sides being isolated from each other, to supply electricity to an apparatus with micro-power consumption. For instance, the high voltage interface device 40 can also be coupled between a controller 50 and a sensor assembly 60.** The first ultrasonic transducer elements 420 are used for converting an electrical power signal inputted from the controller 50 to an ultrasonic wave; the ultrasonic wave is transmitted along the insulation device 410 to the second ultrasonic transducer elements 430, which convert the ultrasonic wave received to a corresponding electrical power signal and output this signal to the sensor assembly 60. Generally known technology may be used to enable the sensor assembly 60 to convert the electrical power signal received thereby to a supply voltage capable of allowing the various components thereof to operate normally.

In addition, the first ultrasonic transducer elements 420 and second ultrasonic transducer elements 430 may also transmit electrical modulation signals to each other. An electrical modulation signal from the controller 50 is converted to an ultrasonic wave by the first ultrasonic transducer elements 420; the ultrasonic wave is transmitted via the insulation device 410 to the second ultrasonic transducer elements 430, which convert the ultrasonic wave to an electrical modulation signal to be outputted and delivered to the **sensor assembly** 60. This electrical modulation signal may contain some initialization information. In addition, an electrical modulation signal from the sensor assembly 60 is converted to an ultrasonic wave by the second ultrasonic transducer elements 430; the ultrasonic wave is transmitted via the insulation device 410 to the first ultrasonic transducer elements 420, which convert the ultrasonic wave to an electrical modulation signal to be delivered to the controller 50. The above electrical modulation signal may include sampling information from the sensor assembly 60, e.g. current and voltage at the high voltage side end.

In one example, within one time period, the first ultrasonic transducer elements 420 convert an electrical power signal inputted from the controller 50 to an ultrasonic wave; the ultrasonic wave is transmitted along the insulation device 410 to the second ultrasonic transducer elements 430, which convert the ultrasonic wave received to a corresponding electrical power signal and output this signal to the sensor assembly 60. Generally known technology may be used to enable the sensor assembly 60 to convert the electrical power signal received thereby to a supply voltage capable of allowing the various components thereof to operate normally.

Within another time period, the first ultrasonic transducer elements 420 convert an electrical modulation signal inputted from the controller 50 to an ultrasonic wave, wherein the electrical modulation signal can be generated using generally known technology and may contain initialization information in the controller 50. The ultrasonic wave is transmitted along the insulation device 410 to the second ultrasonic transducer elements 430, which convert the ultrasonic wave received to a corresponding electrical modulation signal and output this signal to the sensor assembly 60. Generally used technology may be used to enable the sensor assembly 60 to demodulate the electrical modulation signal received, in order to obtain the initialization information. The second ultrasonic transducer elements 430 convert an electrical modulation signal inputted from the sensor assembly 60 to an ultrasonic wave, wherein the electrical modulation signal may be generated using generally known technology and may contain information sampled by the sensor assembly 60. The ultrasonic wave is transmitted along the insulation device 410 to the first ultrasonic transducer elements 420, which convert the ultrasonic wave received to a corresponding electrical modulation signal and output this signal to the controller 50. Generally used technology may be used to enable the controller 50 to demodulate the electrical modulation signal received, in order to obtain the information sampled by the sensor assembly 60.

In another example, a portion of the first ultrasonic transducer elements 420 converts an electrical power signal inputted from the controller 50 to an ultrasonic wave; the ultrasonic wave is transmitted along the insulation device 410 to a portion of the second ultrasonic transducer elements 430, which converts an ultrasonic wave received to a corresponding electrical power signal and outputs this signal to the sensor assembly 60. At the same time, another portion of the first ultrasonic transducer elements 420 and another portion of the second ultrasonic transducer elements 430 transfer information to each other. The first ultrasonic transducer element(s) 420 convert(s) an electrical modulation signal inputted from the controller 50 to an ultrasonic wave, wherein the electrical modulation signal may be generated using generally known technology and may contain initialization information from the controller 50. The ultrasonic wave is transmitted along the insulation device 410 to the second ultrasonic transducer element(s) 430, which convert(s) the ultrasonic wave received to a corresponding electrical modulation signal and output(s) this signal to the sensor assembly 60. Generally used technology may be used to enable the sensor assembly 60 to demodulate the electrical modulation signal received, in order to obtain the initialization information. The other portion of the second ultrasonic transducer elements 430 converts an electrical modulation signal inputted from the sensor assembly 40 to an ultrasonic wave, wherein the electrical modulation signal may be generated using generally known technology and may contain sampled information from the sensor assembly 40. The ultrasonic wave is transmitted along the insulation device 410 to the other portion of the first ultrasonic transducer elements 420, which converts the ultrasonic wave received to a corresponding electrical modulation signal and outputs this signal to the controller 50. Generally used technology may be used to enable the controller 50 to demodulate the electrical modulation signal received, in order to obtain the sampled information.

In one embodiment of the present invention, the first ultrasonic transducer elements or second ultrasonic transducer elements may be an array composed of multiple piezoelectric ceramic elements. The piezoelectric ceramic elements can convert electrical energy to mechanical energy and vice versa. In addition to piezoelectric transducers, ultrasonic transducer elements of other types can of course also be used, for example: an electrostatic ultrasonic transducer element array, an electromagnetic ultrasonic transducer element array, a magnetostrictive transducer, an electrodynamic transducer, an electromagnetic transducer, or a capacitive transducer, etc. Optionally, the frequency of the signal inputted to the piezoelectric ceramic element may be equal to the resonant frequency of the piezoelectric ceramic element, which maximizes the strength of the ultrasonic wave emitted and the efficiency of transmission. Moreover, the piezoelectric ceramic element which receives an ultrasonic wave can be identical to the piezoelectric ceramic element which emits an ultrasonic wave, so that the piezoelectric ceramic element receiving an ultrasonic wave is also in a resonant state, and is thus able to recover the maximum amount of energy. Refer to Fig. 5, which shows a schematic diagram of the microstructure of the ultrasonic transducer element array according to the present invention. To further increase the efficiency of ultrasonic wave transmission, phased array technology may be used to focus an ultrasonic wave emitted by an ultrasonic transducer element at one side on the surface of a corresponding ultrasonic transducer element at the other side.

In one example, the insulating medium in the insulation device 410 is distilled water. An ultrasonic wave emitted by a piezoelectric ceramic element may be transmitted along a glass tube filled with distilled water. Distilled water is an insulating material; moreover, the attenuation rate of ultrasonic waves in distilled water is lower than in air. However, the present invention is not limited to this, and the insulation device may also be insulating oil/fat, insulating gel, a ceramic rod, a glass rod, or another insulating material which provides a high level of insulation and in which ultrasonic waves have a low attenuation rate.

The present invention has been presented and explained in detail above by way of the accompanying drawings and embodiments. However, the present invention is not limited to these disclosed embodiments. Therefore the scope of protection of the present invention should be defined by the attached claims.

## Claims

1. A high voltage interface device (30), comprising:
an optical fiber (310) for communication;
an insulation device (320, 410) for transmitting ultrasonic waves;
a first ultrasonic transducer element (330, 420), positioned at one end of the insulation device (320, 410); and
a second ultrasonic transducer element (340, 430), positioned at the other end of the insulation device (320, 410);
wherein the first ultrasonic transducer element (330, 420) is configured to convert an inputted electrical power signal to a first ultrasonic wave and to transmit the same to the insulation device, and the second ultrasonic transducer element (340, 430) is configured to convert the first ultrasonic wave from the insulation device (320, 410) to an electrical power signal to be outputted;
**characterized in that**
a insulating medium in the insulation device (320, 410) is distilled water.

2. The high voltage interface device as claimed in claim 1 **characterized in that** a frequency of the electrical power signal, a resonant frequency of the first ultrasonic transducer element and the resonant frequency of the second ultrasonic transducer element are the same.

3. The high voltage interface device as claimed in any of claims 1 to 2, **characterized in that** the first ultrasonic transducer element or the second ultrasonic transducer element is a piezoelectric ceramic element.

4. The high voltage interface device as claimed in claim 1, **characterized in** being configured such that an ultrasonic wave emitted by the first ultrasonic transducer element (330, 420) is being focused on a surface of the second ultrasonic transducer element (340, 430) by phased array technology.

5. A system: comprising the high voltage interface device as claimed in any of claims 1 to 4, a controller (50) and a sensor (60), the controller being electrically connected to the first ultrasonic transducer element (330, 420), the sensor being electrically connected to the second ultrasonic transducer (340, 430) element, and the controller and the sensor each being connected to the optical fiber.

## Patentansprüche

1. Hochspannungsschnittstellenvorrichtung (30), umfassend:
eine optische Faser (310) zur Kommunikation;
eine Isoliervorrichtung (320, 410) zum Übertragen von Ultraschallwellen;
ein erstes Ultraschallwandlerelement (330, 420), das an einem Ende der Isoliervorrichtung (320, 410) positioniert ist; und
ein zweites Ultraschallwandlerelement (340, 430), das an dem anderen Ende der Isoliervorrichtung (320, 410) positioniert ist;
wobei das erste Ultraschallwandlerelement (330, 420) ausgestaltet ist, um ein eingegebenes elektrisches Leistungssignal in eine erste Ultraschallwelle zu konvertieren und diese an die Isoliervorrichtung zu übertragen, und wobei das zweite Ultraschallwandlerelement (340, 430) ausgestaltet ist, um die erste Ultraschallwelle aus der Isoliervorrichtung (320, 410) in ein elektrisches Leistungssignal zu konvertieren, welches ausgegeben werden soll;
**dadurch gekennzeichnet, dass**
ein Isoliermedium in der Isoliervorrichtung (320, 410) destilliertes Wasser ist.

2. Hochspannungsschnittstellenvorrichtung nach Anspruch 1, **dadurch gekennzeichnet, dass** eine Frequenz des elektrischen Leistungssignals, eine Resonanzfrequenz des ersten Ultraschallwandlerelements und die Resonanzfrequenz des zweiten Ultraschallwandlerelements dieselben sind.

3. Hochspannungsschnittstellenvorrichtung nach einem der Ansprüche 1 bis 2, **dadurch gekennzeichnet, dass** das erste Ultraschallwandlerelement oder das zweite Ultraschallwandlerelement ein piezoelektrisches Keramikelement ist.

4. Hochspannungsschnittstellenvorrichtung nach Anspruch 1, **dadurch gekennzeichnet, dass** sie so ausgestaltet ist, dass eine von dem ersten Ultraschallwandlerelement (330, 420) emittierte Ultraschallwelle durch Phased Array-Technologie auf eine Oberfläche des zweiten Ultraschallwandlerelements (340, 430) fokussiert wird.

5. System, umfassend die Hochspannungsschnittstellenvorrichtung nach einem der Ansprüche 1 bis 4, eine Steuerung (50) und einen Sensor (60), wobei die Steuerung elektrisch mit dem ersten Ultraschallwandlerelement (330, 420) verbunden ist, der Sensor elektrisch mit dem zweiten Ultraschallwandlerelement (340, 430) verbunden ist, und die Steuerung und der Sensor jeweils mit der optische Faser verbunden sind.

## Revendications

1. Dispositif d'interface haute tension (30), comprenant :
une fibre optique (310) pour la communication ;
un dispositif d'isolation (320, 410) pour transmettre des ondes ultrasonores ;
un premier élément transducteur ultrasonore (330, 420), positionné à une extrémité du dispositif d'isolation (320, 410) ; et
un deuxième élément transducteur ultrasonore (340, 430), positionné à l'autre extrémité du dispositif d'isolation (320, 410) ;
dans lequel le premier élément transducteur ultrasonore (330, 420) est configuré pour convertir un signal électrique entré en une première onde ultrasonore et transmettre celle-ci au dispositif d'isolation, et le deuxième élément transducteur ultrasonore (340, 430) est configuré pour convertir la première onde ultrasonore provenant du dispositif d'isolation (320, 410) en un signal électrique à délivrer ;
**caractérisé en ce que**
un milieu d'isolation dans le dispositif d'isolation (320, 410) est de l'eau distillée.

2. Dispositif d'interface haute tension selon la revendication 1 **caractérisé en ce qu'**une fréquence du signal électrique, une fréquence de résonance du premier élément transducteur ultrasonore et la fréquence de résonance du deuxième élément transducteur ultrasonore sont identiques.

3. Dispositif d'interface haute tension selon l'une quelconque des revendications 1 à 2, **caractérisé en ce que** le premier élément transducteur ultrasonore ou le deuxième élément transducteur ultrasonore est un élément céramique piézoélectrique.

4. Dispositif d'interface haute tension selon la revendication 1, **caractérisé en ce qu'**il est configuré de telle sorte qu'une onde ultrasonore émise par le premier élément transducteur ultrasonore (330, 420) est focalisée sur une surface du deuxième élément transducteur ultrasonore (340, 430) par la technologie des réseaux phasés.

5. Système comprenant le dispositif d'interface haute tension selon l'une quelconque des revendications 1 à 4, un contrôleur (50) et un capteur (60), le contrôleur étant relié électriquement au premier élément transducteur ultrasonore (330, 420), le capteur étant relié électriquement au deuxième élément transducteur ultrasonore (340, 430), et le contrôleur et le capteur étant chacun reliés à la fibre optique.
